Europäisches Patentamt

European Patent Office

Office européen des brevets

(11) Veröffentlichungsnummer: **0 225 451**
**A2**

(12) # EUROPÄISCHE PATENTANMELDUNG

(21) Anmeldenummer: **86114230.5**

(22) Anmeldetag: **14.10.86**

(51) Int. Cl.⁴: **H05K 3/02** , **B30B 5/06** , **B32B 31/20**

(30) Priorität: **15.10.85 CH 4430/85**

(43) Veröffentlichungstag der Anmeldung:
**16.06.87 Patentblatt 87/25**

(84) Benannte Vertragsstaaten:
**AT BE CH DE ES FR GB GR IT LI LU NL SE**

(71) Anmelder: **President Engineering Corp.**
**Florastrasse 11**
**CH-8008 Zürich(CH)**

(72) Erfinder: **Schwarz, Lothar, Dipl.-Ing.**
**Auf den Rotten 18**
**D-5253 Lindlar(DE)**
Erfinder: **Ueberberg, Friedel**
**An der Sülz 47**
**D-5253 Lindlar(DE)**
Erfinder: **Kuehne, Rudolf**
**Linder Weg 114**
**D-5000 Köln 90(DE)**
Erfinder: **Fischer, Dieter**
**Artilleriestrasse 94**
**D-5000 Köln 90(DE)**

(74) Vertreter: **Berg, Wilhelm, Dr. et al**
**Mauerkircherstrasse 45**
**D-8000 München 80(DE)**

(54) Verfahren zur Herstellung von metallkaschiertem Leiterplatten-Basismaterial und Vorrichtung zur Durchführung des Verfahrens.

(57) Bei einem Verfahren zum Herstellen von metallkaschiertem Leiterplatten-Basismaterial durch Verpressen in der Wärme von mit wärmehärtbarem Harz imprägnierten Materialbahnen mit der bzw. den aufzukaschierenden Metallfolien in einer Pressein-richtung wird zur Imprägnierung der Materialbahnen ein Imprägniermittel, das ein katalysatorbe-schleunigtes Harzsystem enthält, verwendet und es werden dann die imprägnierten Materialbahnen zu-sammen mit der bzw. den aufzukaschierenden Metallfolien verpresst.

## Verfahren zur Herstellung von Prepregs und von metallkaschiertem Leiterplatten-Basismaterial und Vorrichtung zur Durchführung des Verfahrens

Die vorliegende Erfindung betrifft ein Verfahren zur Herstellung von Prepregs und von metallkaschiertem Basismaterial für Leiterplatten gemäß dem Oberbegriff des Anspruchs 1 und Vorrichtungen zur Durchführung des Verfahrens.

Es ist bekannt, metallkaschierte Basismaterialien für Leiterplatten durch Verpressen von zugeschnittenen, mit wärmehärtbarem Harz versehenen Bahnmaterialien und Metallfolien in Etagenpressen herzustellen. Ein solches Verfahren liefert Basismaterialien mit innerhalb der Einzelplatte und von Einzelplatte zu Einzelplatte variierender Qualität. Der Pressvorgang dauert beispielsweise bei elf-Etagenpressen einschließlich Aufheizen und Abkühlen über 2 Stunden.

Aus der GB-A-2 108 427 ist ein Verfahren bekannt, bei dem in einer zwei Heizplatten aufweisenden Presse ein intermittierendes Verpressen derart erfolgt, daß eine in die Presse eingeführte, mit Harzpulver bestreute Gewebebahn und eine Kupferfolie jeweils während des Pressvorgangs stillsteht und das Pressprodukt taktweise ausgestossen wird. Auch hier variiert die Quali tät innerhalb der Einzelplatte, was, wenn vom Verbraucher homogene Qualität gewünscht wird, zu großen Mengen an Ausschuß führt. Zudem ist mit den bekannten Harzen eine wirtschaftliche Arbeitsgeschwindigkeit nicht zu erreichen.

Der Einsatz von kontinuierlich arbeitenden Doppelbandpressen, wie sie z.B. von der Herstellung dekorativer Schichtstoffe her bekannt sind, hat bisher ebenfalls nicht zum Erfolg geführt, schon deshalb, weil mit den für die Herstellung von Leiterplatten-Basismaterial bisher gebräuchlichen Harzen eine wirtschaftlich vertretbare Arbeitsgeschwindigkeit nicht zu erreichen ist.

Bei den aus der Literatur bekannten Verfahren zur Herstellung von Leiterplatten-Basismaterial ist eine lange Presszeit von zum Teil über 2 Stunden erforderlich. Diese lange Presszeit bei den konventionellen Mehretagenpressen und dem üblichen wärmehärtbaren Harz wird zum Teil dadurch bedingt, daß ein rascheres Aufheizen bzw. rascheres Abkühlen unter Druck vermieden werden muß, um die Qualitätsunterschiede zwischen den äußeren und inneren Etagen und innerhalb der einzelnen Etagen möglichst gering zu halten. Diese Qualitätsunterschiede werden zum Teil durch den Schiebefluß bedingt, der zu unterschiedlichen Dicken zwischen den Randpartien und den Mittelpartien der einzelnen Tafeln bei zu schnellem Aufheizen bzw. Abkühlen unter Druck führt. Ferner ist es üblich, beim Lagenaufbau für die äußeren Schichten der Tafeln höherwertige Ausgangsstoffe einzusetzen, um damit eine bessere Oberflächenbeschaffenheit zu erreichen. Die Verwendung von Ausgangsstoffen unterschiedlicher Dichten führt indessen zu einer gewissen Inhomogenität des Lagenaufbaues. Zudem ist hierbei eine aufwendige Lagerhaltung und eine entsprechende Kontrolle bei der Verarbeitung nötig.

Aufgabe der Erfindung ist es, die Nachteile des Standes der Technik zu beseitigen und ein Verfahren zur Herstellung von Prepregs und von metallkaschiertem Basismaterial für Leiterplatten und Mittel zur Ausführung des Verfahrens vorzusehen, das wirtschaftlich, kostensparend und technisch einfach zu handhaben ist, das es zudem erlaubt, den zeitlichen Aufwand erheblich zu reduzieren und eine vollkommene Homogenität des Lagenaufbaus gewährleistet. Dies alles durfte jedoch keineswegs zu Lasten der Qualität der Verfahrensprodukte gehen, sondern es sollten im Gegenteil die Eigenschaften des Leiterplatten-Basismaterials noch verbessert werden. Weitere Zusatz-und Nebenaufgaben sind auch aus den nachfolgend geltend gemachten Vorteilen ersichtlich.

Die erfindungsgemäße Aufgabe wird durch die Merkmale des kennzeichnenden Teils des Anspruchs 1 gelöst. Besonders günstige Ergebnisse werden dann erzielt, wenn zur Imprägnierung ein Harzsystem mit einem beschleunigten Epoxid-Härter-Katalysatorsytem verwendet wird, namentlich dann, wenn als Beschleuniger Pyridin-Derivate und/oder Imidazol, gegebenenfalls substituiert, enthalten ist. Gemäß einem auf die gleichen Erfinder zurückgehenden älteren Erfindungsvorschlag gehört es zwar zum Stand der Technik, daß man manche Leiterplatten-Basismaterialien unter Einhaltung bestimmter Bedingungen mit beschleunigten Harzsystemen herstellen kann (EP 0 158 027 A2). Für den dort genannten Gegenstand wird im vorliegenden Rahmen Schutz jedoch nicht begehrt.

Vorteilhafte Ergebnisse werden auch erzielt, wenn in dem zur Imprägnierung verwendeten Harzsystem auch Phenol-Härter-Katalysatorsysteme enthalten sind.

Nach dem erfindungsgemäßen Verfahren ist es möglich, daß durch den Einsatz von katalysatorbeschleunigten Harzsystemen die Leistung der Imprägnieranlagen um etwa 20% gegenüber der Verwendung von für die Herstellung von Leiterplatten-Basismaterial konventionellen Harzen gesteigert wird. Insbesondere ist von Vorteil, daß die Erfindung die Durchführung des Verfahrens in kontinuierlicher oder intermittierender Weise erlaubt. Es können dazu die mit dem erfindungsgemäß beschleunigten Harzsystem imprägnierten Materialbahnen in Doppelbandpressen verarbeitet werden. Durch das raschere Anspringen der beschleunigten Harze wird ein rascheres Aufheizen und rascheres Abkühlen unter Druck möglich und gleichzeitig der Fluß und damit der gefürchtete Schiebefluß eingeengt. Die Dickentoleranz zwischen den Randpartien und der Mittelpartie werden deutlich kleiner, woraus eine erhöhte Produktionssicherheit, geringerer Ausschuß und engerer Toleranzbereich der erhaltenen Leiterplatten-Basismaterialien resultiert. Die Verarbeitung in Ein-oder Mehretagenpressen, wo eine deutliche Verringerung des Schiebeflusses beobachtet werden kann, ist jedoch nicht ausgeschlossen.

Als Beschleuniger in dem Epoxi-Harz-Härter-Katalysator-System sind u.a. folgende Pyridinverbindungen geeignet:

2-Benzoylpyridin
3-Benzoylpyridin
4-Benzoylpyridin
2-Benzylpyridin
3-Benzylpyridin
4-Benzylpyridin
2-Benzylaminopyridin
4-Dimethylaminopyridin
2-Methoxypyridin
4-tert.-Butylpyridin
3-Cyanpyridin
2-Hydroxypyridin
6-Amino-2-pyridin
2-Aminopyridin
3-Aethylpyridin
3-Aethyl-4-Methylpyridin
2-Phenylpyridin
2,6-Diaminopyridin
3-Methylpyridin
2-(Aminomethyl)-pyridin
2-Amino-4-methylpyridin
2,4-Dimethylpyridin

Eine zweite vorteilhafte Gruppe von Beschleunigern hierfür sind die an sich bekannten substituierten Imidazol-Verbindungen einschließlich des Imidazols selbst, und zwar:

N-Methylimidazol
2-Methylimidazol
2-Phenylimidazol
4-Phenylimidazol
4-Methylimidazol
2-Methylbenzimidazol
5,6-Dimethylbenzimidazol
1-Methyl-2-phenylbenzimidazol
1,2-Dimethylimidazol
4,5-Diphenylimidazol
2-Aethyl-4-Methylimidazol
Carbonyldiimidazol

Imidazol
2-Undecylimidazol
1-Cyanoäthyl-2-phenylimidazol
2-Phenylbenzimidazol

Besonders gute Resultate werden durch eine Kombination der obengenannten Pyridin-bzw. Imidazol-Bebeschleuniger mit dem von konventionellen Harzen als Härter bekanntem Dicyandiamin bzw. Benzyldimethylamin erzielt.

Mit diesen erfindungsgemäßen beschleunigten Harz-Härter-Katalysator-Systemen wird die Aushärtezeit bis auf etwa 2 Minuten reduziert. Durch die praktische Ausschaltung des gefürchteten Schiebeflusses wird zudem ein Erzeugnis von außerordentlich gleichmäßiger hoher Qualität erreicht.

Das beschleunigte Harz-Härter-Katalysator-System kann 0,2 bis 0,8 Gew.% des Beschleunigers oder der Beschleunigermischung, bezogen auf das Festharz, enthalten. Der Pressvorgang kann unter Vakuum stattfinden. Häufig hat sich eine Temperung des Verfahrensproduktes als vorteilhaft erwiesen.

Meistens wird so vorgegangen, daß zur Bildung eines aus mehreren Lagen bestehenden Leiterplatten-Basismaterials einzelne, mit dem beschleunigten Harz-System imprägnierte Materialbahnen von verschiedenen Rollen abgewickelt und mit mindestens einer von einer weiteren Rolle abgewickelten, aufzukaschierenden Metallfolienbahn, gegebenenfalls gleichzeitig zusammengeführt werden und daß das so gebildete Band taktweise in die Presse, vorzugsweise Doppelband-presse, eingeführt und heiß verpreßt wird. Die Materialbahnen können vor dem Pressvorgang auf Endlänge geschnitten werden und anschließend zusammen mit der gegebenenfalls auf Endlänge geschnittenen Metallfolienbahn in die druckwirksame Zone gelangen. Es wird häufig auch so verfahren, daß zwischen den verpreßten Abschnitten des Leiterplatten-Basismaterials nicht verpresste Abschnitte des Basismaterials gebildet werden oder wenigstens eine Metallfolien-verbindung zwischen den verpreßten Abschnitten belassen wird.

Vor oder nach dem Schneiden in ihrer relativen Lage zueinander können die Materialbahnen durch Klammern, Nieten, Heften oder dergleichen im Randbereich fixiert und anschließend taktweise in die Presse eingeführt werden. Sollen zwei oder mehrere einseitig oder beidseitig mit Metallfolie kaschierte Leiterplatten-Basismaterialien hergestellt werden, so werden zum Heißverpressen zwischen den Bahnen bzw. Abschnitten Trennfolien gleichzeitig in die Presse eingeführt und damit verpreßt und die so erhaltenen Materialien nach dem Pressvorgang mittels der Trennfolien wieder voneinander getrennt.

Mit Vorteil wird so vorgegangen, daß in einem ersten Arbeitstakt die Material-und aufzukaschierenden Metallfolien-Bahnen in eine Heißpresszone eingeführt werden und dann in einem zweiten Takt eine Abkühlung unter Druck in einer Kühlzone erfolgt und schließlich im dritten Arbeitstakt das Leiterplatten-Basismaterial am Rand beschnitten und gegebenenfalls abgelängt wird. Es ist auch möglich, im ersten Arbeitstakt die Bahnen in eine Presszone einzuführen und dort mittels Hochfrequenz zu erwärmen und anschließend dort abzukühlen und anschließend im zweiten Arbeitstakt das Leiterplatten-Basismaterial am Rand zu beschneiden und abzulängen.

Beim Zusammenführen oder Schneiden der Material-und Metallfolien-Bahnen sollten Reinstraumbedingungen bzw. Vakuum vorliegen. Es hat sich im übrigen bewährt, die aufzukaschierenden Metallfolien vorzuwärmen.

Doppelbandpressen haben sich für das erfindungsgemäße Verfahren besonders bewährt. Sie erlauben eine kontinuierliche oder zumindest teilkontinuierliche Fertigung. Dabei hat sich gegenüber einer für das Aufheizen und das Abkühlen verwendeten Einetagen-Presse die Kombination einer konventionellen Einetagen-Presse als Heizzone und einer zweiten konventionellen Einetagen-Presse als Kühlzone innerhalb eines von den eigentlichen Doppelbandpressen her bekannten Stahlbandpaares, welches bei kurzzeitiger Druckentlastung taktweise bewegt wird, als besonders geeignet erwiesen. Bei einer solchen modifizierten Doppelbandpresse ist die Aufbringung eines Druckes in den benötigten Grössenordnungen von 65 bis 80 bar und darüber ohne besonderen Aufwand und in überdies genau beherrschbarer Form bezüglich Druckgleichheit und Temperatur möglich. Überhaupt haben sich Pressen mit Drücken bis 100 bar bewährt.

Vor der Presszone sind im allgemeinen Einzugsumlenktrommelpaare, die beheizt oder gegebenenfalls gekühlt sein können, insbesondere für die Materialbahnen, angeordnet. Vor der Doppelbandpresse können ferner in Einzugsrichtung Einrichtungen zum Lagern, Abrollen und Führen der Materialbahnen und der Metallfolienbahnen vorgesehen sein. Die Einlaufzone ist häufig mit Hitzeschildern zur Vermeidung allzu großer Wärmeabstrahlung auf die Materialbahnen versehen. Für die Metallfolienbahnen können beheizbare Einzugsumlenkungstrommeln vorgesehen sein, die ebenfalls mit Hitzeschildern zur Eindämmung der Strahlungswärme ausgerüstet sein können.

Im Austrittsbereich der Vorrichtung ist im allgemeinen ein Auszugs-Umlenktrommelpaar vorgesehen. Zudem können Randbeschnittvorrichtungen und gegebenenfalls Ablängevorrichtungen vorgesehen sein.

Bisher marktgängig sind einerseits Leiterplatten von 1,5 mm und andererseits Leiterplatten von 1,6 mm, deren Toleranzen nach Norm ± 0,13 mm betragen dürfen. Mit dem erfindungsgemäßen Verfahren liegen die Toleranzen innerhalb 1,52 mm am Rand und 1,55 mm in der Mitte der einzelnen Tafeln, mit der Folge, daß man mit einem einzigen Erzeugnis auskommt, da das nach dem erfindungsgemäßen Verfahren hergestellte Produkt innerhalb der Toleranzen für beide Erzeugnisse liegt. Die produktionsmäßigen Vorteile inklusive einer vorteilhaften Lagerhaltung usw. liegen auf der Hand.

Bisher wurden für eine 1,5 mm Leiterplatte beispielsweise vier Lagen Glasgewebe à 230 g/m² und drei Lagen à 200 g/m² verwendet und für 1,6 mm starke Leiterplatten sechs Lagen à 200 g/m² und zwei Lagen à 230 g/m². Bei dem erfindungsgemäßen Verfahren ist es nun möglich, für das Einheitsprodukt eine einzige Qualität Glasfasergewebe zu verwenden, die beispielsweise aus acht Lagen à 200 g/m² besteht. Daraus ergibt sich, daß die teurere Qualität von 230 g/m² nicht mehr notwendig ist mit den entsprechenden logistischen Vorteilen.

Ferner wird dadurch eine vollkommene Homogenität des Lagenaufbaus erreicht, da nur eine einzige Glasfasergewebesorte verwendet wird.

Dank der erfindungsgemäßen gewaltigen Beschleunigung des Aushärtevorganges gegenüber den bekannten, konventionell beschleunigten Harzsystemen wird es nun möglich, in Einetagen-Pressen wirtschaftlich zu fertigen, womit überdies eine weitere Qualitätssteigerung dadurch möglich ist, als die bei Mehretagenpressen unvermeidlichen Unterschiede zwischen den Erzeugnissen aus den äußeren und inneren Etagen entfallen.

Selbst bei einer Verarbeitung der mit dem erfindungsgemäßen beschleunigten Harzsystem imprägnierten Materialbahnen in eine Mehretagenpresse wird z.B. unter Vakuum neben hoher Porenfreiheit eine Verbesserung auch der geometrischen Werte erzielt. Dieser Effekt wird vermutlich durch die Kombinationswirkung, d.h., einerseits durch die Verwendung des beschleunigten Harzsystems und damit der Beseitigung des gefürchteten Schiebeflusses und andererseits durch das Vakuum bedingt. Dadurch wird eine Einengung der Toleranzen, die in der Elektronik immer erwünscht ist, erreicht, wodurch produktionstechnisch sich interessante Aspekte ergeben.

Anhand des in der beiliegenden Zeichnung dargestellten Ausführungsbeispiels einer zur Durchführung des erfindungsgemäßen Verfahrens geeigneten Vorrichtung wird die Erfindung nunmehr näher erläutert.

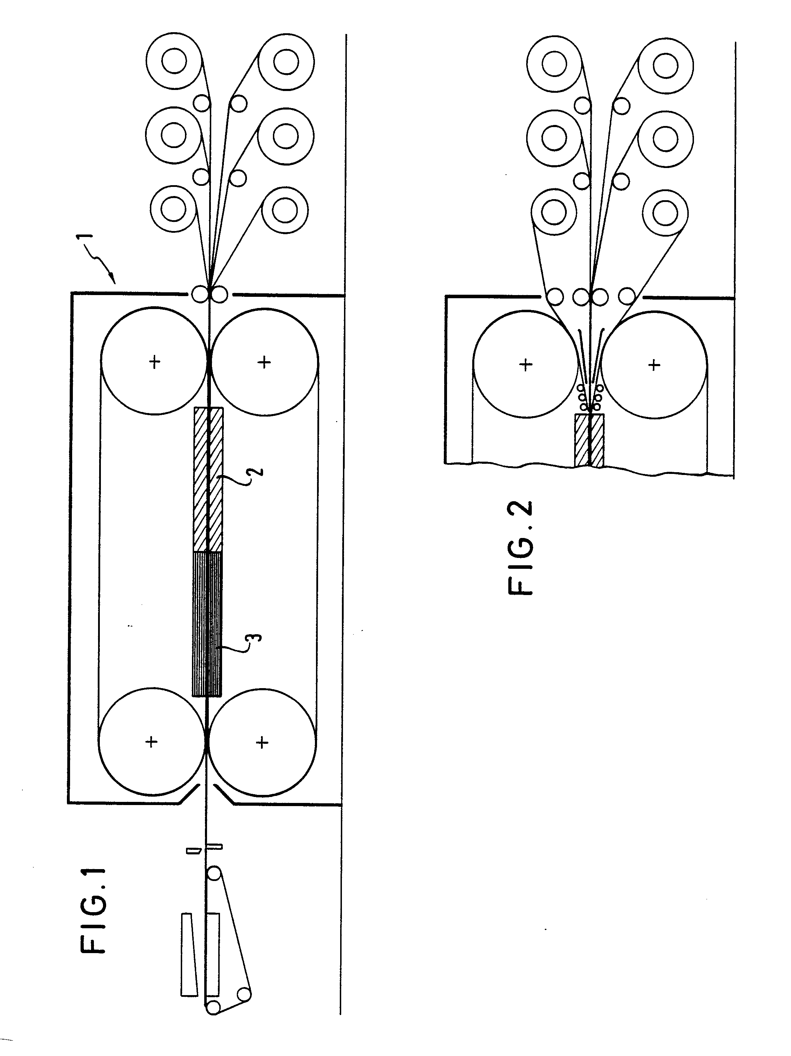

Die in der Figur 1 dargestellte Vorrichtung weist eine Doppelbandpresse 1 mit einer Heizpresse 2 und einer dieser nachgeschalteten Kühlpresse 3 auf. Die erfindungsgemässe Doppelbandpresse 1 arbeitet mit taktweisem Vorschub. Die geheizte Zone 2 und die gekühlte Zone 3 weisen gleiche Abmessungen auf. In einer bevorzugten Ausführungsform ist eine Heizzone und eine Kühlzone von jeweils 3 m Länge und einer Breite von 1,3 m vorgesehen. Die Doppelbandpresse weist vor der druckwirksamen Zone 2 ein Einzugs-Umlenktrommelpaar auf, das gekühlt werden kann. Nach der Kühlpresse 3 ist ein entsprechend ausgestaltetes Auszugs-Umlenktrommelpaar vorgesehen.

Vor der Doppelbandpresse sind Spindelabwickler mit je zwei Spindeln für Prepregs, d.h. mit dem Harzsystem versehene Glasfasergewebe und ein weiterer Spindelabwickler mit zwei Spindeln für die Metallfolien, d.h. im vorliegenden Fall für Kupferfolien, angeordnet. Zwischen den Spindelabwicklern für die Materialbahnen bzw. für die Metallfolien sind Führungsrollen vorgesehen.

In Produktionsrichtung hinter der Doppelbandpresse befindet sich eine Randbeschnittvorrichtung und anschliessend eine Ablängvorrichtung.

Im folgenden wird die Funktionsweise der erfindungsgemässen Doppelbandpresse kurz beschrieben. Von den Spindelabwicklern werden vier Prepregbahnen, die mit dem erfindungsgemäss beschleunigten Harzsystem imprägniert sind, abgezogen, zusammengebracht und in die Heizpresszone taktweise eingeführt. Gleichzeitig werden von zwei weiteren Spindeln des Spindel abwicklers für die Metallfolien Kupferfolien geliefert. In einem ersten Arbeitstakt werden die Materialbahnen mit den Metallfolien zusammengepresst. Der dabei mögliche Druck beträgt bis zu 100 bar.

Wenn nur einseitig kaschiertes Basismaterial hergestellt wird, kann anstelle der Kupferfolie eine hitzebeständige Trennfolie auf die entsprechende Spindel aufgewickelt werden und in die Doppelbandpresse einlaufen. Als Trennfolie kann z.B. eine silikonisierte oder mit Polytetraethylen kaschierte Aluminiumfolie verwendet werden. Die Trennfolie kann nach dem Auslaufen aus der Doppelbandpresse von der fertigen Basismaterialbahn abgezogen und erneut verwendet werden.

Nach dem Pressvorgang erfolgt eine kurzzeitige, fast vollständige Druckentlastung und der taktweise Vorschub des gepressten Abschnitts in die Kühlzone, wo das verbundene Basismaterial unter Druck abgekühlt wird. Nach Abschluss des Kühlvorgangs wird das Basismaterial weitertransportiert und in der nachfolgenden Randbeschnittvorrichtung und der Ablängvorrichtung in die gewünschten Abmessungen gebracht.

Das Endprodukt ist durch nichtverpresste, d.h. unbrauchbare Abschnitte, miteinander verbunden, die als Abfall ausscheiden. Die Temperatur in der Heizzone beträgt ca. 190°C. Im nachfolgenden Kühlbereich wird die Basismaterialbahn auf ca. 100°C abgekühlt. Zwischen Kühlzone und Randbeschnittvorrichtung kann eine Nachtemperierzone für die Formstabilisierung des Basismaterials angeordnet sein.

Obwohl das erfindungsgemässe Verfahren anhand eines sechsschichtigen Basismaterials veranschaulicht worden ist, können selbstverständlich auch solches mit einer anderen Schichtenzahl hergestellt werden.

Unter Verwendung von Trennfolien ist es ferner möglich, mehrere Basismaterialschichten gleichzeitig herzustellen.

Die geschilderten Betriebsbedingungen sind in erster Linie von dem verwendeten beschleunigten Harz-System abhängig und können entsprechend variiert werden.

Das erfindungsgemässe Verfahren bzw. die erfindungsgemässe Vorrichtung können nicht nur zum Kaschieren mit Kupfer, sondern auch mit anderen Metallfolien angewendet werden. Insbesondere eignen sie sich zum Kaschieren mit Kombinationsfolien, z.B. Cu/Al, wie sie für Feinstleiterplatten (sogenannte etchible/stripable Platten) eingesetzt werden.

Die Materialverluste, die bei dem oben geschilderten Verfahren aufgrund der nichtverpressten Abschnitte entstehen, sind von einer gewissen wirtschaftlichen Bedeutung. Zur Vermeidung dieses Abfalls werden in einer besonderen Ausführungsform die Prepregbahnen auf die endgültige Endlänge bereits abgelängt und somit in entsprechendem Abstand zwischen den Metallfolienbahnen in die Presse eingeführt. In einer weiteren besonderen Ausführungsform werden auch die Metallfolien vor der Presse abgelängt. Dabei ist streng darauf zu achten, dass kein Staub entsteht bzw. durch geeignete Vorkehren wie Vakuum der entstehende Staub von den Prepreg-und Metallfolienflächen fern gehalten wird. Es hat sich ferner als zweckmässig erwiesen, die Materialabschnitte in ihrer relativen Lage zueinander mechanisch zu fixieren, was z.B. durch Heften, Klammern oder Nieten in dem ohnehin später abzuschneidenden Randbereich geschehen kann. Auf diese Weise wird ein quasi-kontinuierliches Verfahren unter Vermeidung von Materialverlusten erreicht.

Es hat sich grundsätzlich als vorteilhaft erwiesen, die Kupferfolien aufzuwärmen. Eine solche Vorwärmung ergibt sich zum Teil mehr oder weniger zwangsläufig dadurch, dass die aussen anliegenden Kupferfolien ohnehin stärker erwärmt werden als der Glasgewebekern. In einer besonderen Ausführungsform der erfindungsgemässen Doppelbandpresse, welche in Figur 2 dargestellt wird, werden die Einzugstrommeln in grösserem Abstand zueinander angeordnet und zwecks Erwärmung der an den Einzugstrommeln entlang geführten Metallfolien beheizt. Im Anschluss an das Einzugs-Umlenkrollenpaar sind Stützrollen für die Stahlbänder vorgesehen. Zur Vermeidung einer Erwärmung der dem Einzugs-Umlenktrommelpaar nächstgelegenen Teile der Prepregbahnen ist ein Hitzeschildpaar vorgesehen. Dieses kann aus einem gekühlten Blech bestehen. Als Kühlung dienen Kühlschlangen, die aus Kupfer bestehen können, in denen die Durchflussgeschwindigkeit eines Kühlmittels steuerbar ist, so dass eine genaue Temperatursteuerung erreicht wird. Anstatt der Kühlschlangen können auch Kühltaschen mit Zwangsführung vorgesehen werden. Die Hitzeschilder sind in horizontaler Richtung verschiebbar angeordnet, so dass die Prepregbahnen in dieser besonderen Ausführungsform auch bezüglich ihrer räumlichen Anordnung je nach Bedarf vor der Temperatureinwirkung der in dieser Ausführungsform beheisten Einlauftrommeln - schützbar sind.

Bei einer weiteren besonderen Ausführungsform kann die bereits zusammengeführte Prepregbahn auf der ganzen Länge des nächsten Taktvorschubes ihrerseits leicht vorgewärmt werden, um ein noch rascheres Anspringen des Harzes in der Heizzone zu bewirken.

Die erfindungsgemässe Presse findet eine weitere Anwendung zur Herstellung von metallkaschiertem Basismaterial für Leiterplatten, wenn statt dem Glasfasergewebe Papier und statt dem erfindungsgemäss beschleunigten Harzsystem auf Epozidbasis ein entsprechend beschleunigtes Harzsystem auf Phenolbasis verwendet wird. Die Kombination der billigeren Ausgangsstoffe mit dem quasi-kontinuierlichen bzw. in kurzen Takten arbeitenden Presse ermöglicht eine besonders wirtschaftliche Herstellung.

Die Erfindung wird anhand der nachfolgenden Beispiele weiter veranschaulicht:

Beispiel 1

Ein Glasgewebe in gefinishter Ausführung, wie es üblicherweise bei kupferkaschierten Glasfaser-Epoxidharz-Laminaten für Leiterplatten verwendet wird, mit einem Gewicht von 200 g/m² wurde mit einer Harzlösung, bestehend aus 100 Teilen eines polymeren, teilbromierten Bisphenol-A-Glycidyläthers mit einem Anteil expoxidierten Novolackes von 1 bis 15%, vorzugsweise von 5 bis 12%, 3,2 Teilen Dicyandiamid, 0,28 Teilen 3-Methylpyridin und 80 Teilen Methylglykol getränkt. Das so getränkte und bei 165°C getrocknete Prepreg hatte einen Harzgehalt von 42% und einen Harzfluss von 10%. Sieben dieser Prepregs wurden bei einer auf 195°C ansteigenden Temperatur unter einem Druck von 55 bar auf der erfindungsgemässen Vorrichtung mit doppelseitiger 35μm dicker Kupferfolienauflage zu einem 1,5 mm starken Laminat verpresst. Die Prüfung des Laminates ergab überraschenderweise über dem Durchschnitt liegende positive Resultate in der Dimensionsstabilität bei sonst mit handelsüblichen Laminaten gleichwertigen Eigenschaften.

Das erhaltene Laminat weist eine Dickentoleranz von ± 3/100 mm auf. Vergleichsweise sehen die Normen für starre Laminate eine Toleranz von ± 13/100 mm vor, die bisher von den Produkten auch voll ausgenützt wurde.

Beispiel 2

Ein Glasgewebe, wie in Beispiel 1 aufgeführt, wurde mit einer Harzlösung, bestehend aus 100 Teilen eines polymeren, teilbromierten Bisphenol-A-Glycidyläthers mit einem Anteil epoxidierten Novolackes von 1 bis 15%, vorzugsweise von 5 bis 12%, 3,4 Teilen Dicyandiamid, 0,33 Teilen 4-Dimethylaminopyridin und 80 Teilen Methylglykol getränkt. Das so getränkte und bei 170°C getrocknete Prepreg hatte einen Harzgehalt von 44% und einen Harzfluss von 8%. Mehrere dieser Prepregs wurden mit doppelseitiger 35 μm Kupferfolienauflage bei einer bis 200°C ansteigenden Temperatur unter einem Druck von 50 bar auf der erfindungsgemässen Vorrichtung zu einem 1,5 mm starken Laminat verpresst. Die Prüfung des Laminates ergab auch in dieser Ausführung über der Norm liegende Werte in der Dimensionsstabilität bei sonst vergleichbaren Laminateigenschaften zu handelsüblichen Produkten.

Beispiel 3

Mit einer Harzmischung, bestehend aus 100 Teilen eines polymeren, teilbromierten Bisphenol-A-Glycidyläthers mit einem Anteil epoxidierten Novolackes von 1 bis 15%, vorzugsweise von 5 bis 12% und mit einem Epoxid-Aequivalentgewicht zwischen 350 und 520, 3,0 Teilen Dicyandiamid, 0,40 Teilen 2-Amino-4-methylpyridin und 80 Teilen Methylglykol wurde ein 100 g/m² schweres Glasgewebe mit gleichem Verwendungszweck wie in Beispiel 1 dargelegt, getränkt und bei 165°C getrocknet. Der Harzgehalt betrug 44% und der Harzfluss 10%. Zwei dieser Prepregs wurden mit einseitiger 35μm dicker Kupferfolienauflage unter Verwendung einer Trennfolie bei einer auf 190°C ansteigenden Temperatur unter einem Druck von 50 bar auf der erfindungsgemässen Vorrichtung zu einem 0,2 mm starken Laminat verpresst. Die Prüfung ergab gleich gute Ergebnisse wie bei Beispiel 2.

Beispiele 4 bis 13

Die Rezepturen bzw. Betriebsbedingungen der Beispiele 4 bis 13 sind in der nachfolgenden Tabelle zusammengestellt.

| Beispiel | 4 | 5 | 6 | 7 | 8 | 9 | 10 | 11 | 12 | 13 |
|---|---|---|---|---|---|---|---|---|---|---|
| Harzanteil | 100 | 100 | 100 | 100 | 100 | 100 | 100 | 100 | 100 | 100 |
| Epoxidäquivalentgewicht | 350/520 | 350/520 | 400/500 | 400/500 | 360/410 | 360/410 | 360/410 | 360/500 | 360/500 | 360/500 |
| Anteil epoxidierter Novolack im Grundharz | 5 | 5 | 5 | 5 | 10 | 10 | 10 | 5 | 10 | 15 |
| Dicyandiamid | 3,3 | 3,3 | 3,3 | 3,0 | 3,0 | 3,4 | 3,1 | 3,2 | 3,2 | 3,0 |
| Methylglykol | 80 | 80 | 80 | 80 | 80 | 80 | 80 | 80 | 80 | 80 |
| Benzyldimethylamin | 0,10 | | 0,15 | 0,10 | | 0,20 | | | 0,14 | 0,18 |
| Carbonyldiimidazol | 0,17 | | | | | | | 0,24 | | |
| 4-Methylimidazol | | 0,27 | | | | 0,21 | | | | |
| 2-Methylimidazol | | | 0,28 | | | | 0,15 | | | |
| 2-Methylbenzimidazol | 0,22 | | | | | | 0,18 | | | |
| 2-Phenylimidazol | | | | 0,30 | 0,21 | | | | | |
| 2-Ethyl-4-methylimidazol | | | | | 0,21 | | | 0,22 | | 0,29 |
| 2-Amino-4-methylpyridin | | | | | | | 0,28 | | 0,30 | |
| 4-Dimethylaminopyridin | | 0,2 | | 0,19 | | | | | | |
| 4-tertiäres Butylpyridin | | | 0,16 | | | 0,17 | | | | |
| 3-Benzylpyridin | | | | | 0,25 | | | 0,15 | | |
| Glasgewebe g/m$^2$ | 200 | 200 | 200 | 200 | 200 | 100 | 100 | 48 | 100 | 48 |
| Lackiertemp. b. Prepregherstellung | 160 | 160 | 170 | 165 | 165 | 170 | 160 | 165 | 165 | 160 |
| Harzgehalt | 43 | 43 | 44 | 44 | 43 | 49 | 48 | 50 | 50 | 60 |
| Harzfluß | 8 | 9 | 8 | 10 | 9 | 11 | 10 | 8 | 9 | 8 |
| Preßtemp. (max.) | 195 | 190 | 190 | 195 | 190 | 190 | 195 | 195 | 190 | 190 |
| Preßdruck in bar | 40 | 45 | 50 | 50 | 50 | 45 | 50 | 45 | 45 | 40 |
| Laminatstärke mm | 1,6 | 1,5 | 1,6 | 1,2 | 1,0 | 0,17 | 0,54 | 0,05 | 0,25 | 0,15 |
| Cu-Belegung 35 µ e = einseitig/z = zweiseitig | e | z | e | z | z | z | z | z | z | z |
| Trennfolie | x | – | x | – | – | – | – | – | – | – |

Beispiel 14

Ein Baumwollpapier mit einem Gewicht von 110 g/m² wurde mit 33 g einer Phenolharzlösung, bestehend aus 40% eines wäßrigen niedermolekularen Phenolvorimprägnierharzes, 5,2% Tetrabrombisphenol-A, 4,8% eines Polyalkylenglykoldigly-cidylesters und 50% Lösungsmittel getränkt.

Das so getränkte und bei 120°C bis170°C getrocknete Papier hatte einen Harzgehalt von 23% und einen unter 2% liegenden Anteil flüchtiger Bestandteile, gemessen 5 Minuten bei 160°C.

Anschließend wurde eine weitere Imprägnierung mit 190g einer Harzformulierung bestehend aus 42,6% eines modifizierten Diglycidylesters einer dimeren Säure, 13,5% Tetrabrombishphenol-A, 2,9% Antimontrioxid, 1,8% Dicyandiamid, 0,7% 2-Phenylimidazol mit 38,5% Methylglykol durchgeführt.

Das so zweifach getränkte und bei 110°C bis 180°C getrocknete Papier hatte einen Harzfluß von 7%.

Sechs dieser Prepregs wurden bei einer auf 210°C ansteigenden Temperatur unter einem Druck von 45 bar auf einer Doppelbandpresse mit doppelseitiger 35 μm dicker Cu-Folienauflage zu einem 1,6 mm starkem Laminat verpreßt.

Die Prüfung des Laminates ergab überraschenderweise über dem Durchschnitt liegende positive Resultate in der Stanzbarkeit bei einer Lötbadbeständigkeit, die weit über dem Maß herkömmlicher FR₂-Laminate lag.

**Ansprüche**

1. Verfahren zum Herstellen von metallkaschiertem Leiterplatten-Basismaterial durch Verpressen in der Wärme von mit wärmehärtbarem Harz imprägnierten Materialbahnen mit der bzw. den aufzukaschierenden Metallfolien in einer Presseinrichtung, **dadurch gekennzeichnet,** daß zur Imprägnierung der Materialbahnen ein, ein katalysatorbeschleunigtes Harzsystem enthaltendes Imprägniermittel verwendet wird und daß die imprägnierten Materialbahnen zusammen mit der bzw. den aufzukaschierenden Metallfolien verpresst werden.

2. Verfahren nach Anspruch 1, **dadurch gekennzeichnet,** daß das Imprägniermittel als Harzsystem ein beschleunigtes Epoxyd-Härter-Katalysatorsystem enthält.

3. Verfahren nach Anspruch 1 oder 2, **dadurch gekennzeichnet,** daß das Imprägniermittel als beschleunigtes Harzsystem ein PhenolHärter-Katalysatorsystem enthält.

4. Verfahren nach einem oder mehreren der Patentansprüche 1 bis 3, **dadurch gekennzeichnet,** daß das Harzsystem als Beschleuniger eine oder mehrere Verbindungen aus den folgenden Gruppen enthält: Substituierte Pyridinverbindungen, Imidazol und/oder substituiertes Imidazol.

5. Verfahren nach einem oder mehreren der Patentansprüche 1 bis 4, **dadurch gekennzeichnet,** daß zusätzlich Dicyandiamin und/oder Benzyldimethylamin enthalten ist.

6. Verfahren nach einem oder mehreren der vorangehenden Patentansprüche 1 bis 5, **dadurch gekennzeichnet,** daß das beschleunigte Harz-Härter-Katalysatorsystem 0,2 bis 0,8 Gew.-% des Beschleunigers oder der Beschleunigermischung, bezogen auf das Festharz, enthält.

7. Verfahren nach einem oder mehreren der vorangehenden Ansprüche, **dadurch gekennzeichnet,** daß der Pressvorgang im Vakuum stattfindet.

8. Verfahren nach einem oder mehreren der vorangehenden Patentansprüche 1 bis 7, **dadurch gekennzeichnet,** daß zur Bildung eines aus mehreren Lagen bestehenden Leiterplatten-Basismaterials einzelne mit dem beschleunigten Harzsystem imprägnierte Materialbahnen von verschiedenen Rollen abgewickelt und mit mindestens einer, von einer weiteren Rolle abgewickelten, aufzukaschierenden Metallfolie gegebenenfalls gleichzeitig zusammengeführt werden und daß das so gebildete Band taktweise in die Presse, vorzugsweise Doppelbandpresse, eingeführt und heißverpreßt wird.

9. Verfahren nach einem oder mehreren der vorangehenden Patentansprüche 1 bis 8, **dadurch gekennzeichnet,** daß die Materialbahnen vor dem Pressvorgang auf die Endlänge geschnitten werden und anschließend zusammen mit der gegebenenfalls auf Endlänge geschnittenen Metallfolienbahn in die druckwirksame Zone gelangen.

10. Verfahren nach einem oder mehreren der vorangehenden Ansprüche 1 bis 9, **dadurch gekennzeichnet,** daß zwischen verpressten Abschnitten des Leitplatten-Basismaterials nicht verpresste Abschnitte des Basismaterials gebildet werden oder eine Metallfolienverbindung belassen wird.

11. Verfahren nach einem oder mehreren der vorangehenden Ansprüche 1 bis 10, **dadurch gekennzeichnet,** daß die bandförmigen Materialien vor bzw. beim Schneiden in ihrer relativen Lage zueinander durch Klammern, Nieten, Heften oder dergleichen im Randbereich fixiert und anschließend taktweise in die Presse eingeführt werden.

12. Verfahren nach einem oder mehreren der vorangehenden Patentansprüche 1 bis 11, **dadurch gekennzeichnet,** daß im ersten Arbeitstakt die Materialien und aufzukaschierenden Metallfolien-Bahnen in eine Heiz-Presszone eingeführt werden, daß im zweiten Takt eine Abkühlung unter Druck in einer Kühlzone erfolgt und daß im dritten Arbeitstakt das Leiterplatten-Basismaterial am Rand beschnitten und gegebenenfalls abgelängt wird.

13. Verfahren nach einem oder mehreren der vorangehenden Patentansprüche 1 bis 11, **dadurch gekennzeichnet,** daß im ersten Arbeitstakt die Bahnen in eine Presszone eingeführt und dort mittels Hochfrequenz erwärmt und anschließend einer Abkühlung unterworfen werden und daß im zweiten Arbeitstakt das Leiterplatten-Basismaterial am Rand beschnitten und gegebenenfalls abgelängt wird.

14.Verfahren nach einem oder mehreren der vorangehenden Ansprüche, **dadurch gekennzeichnet,** daß die aufzukaschierende Metallfolie bzw. Metallfolien vorgewärmt werden.

15. Vorrichtung zur Durchführung des Verfahrens nach einem oder mehreren der vorangehenden Patentansprüche 1 bis 14, **gekennzeichnet durch** eine Doppelbandpresse mit taktweisem Vorschub, die Presse eine Heizzone und eine sich daran anschließende Kühlzone aufweist, vor der Heizzone ein gegebenenfalls gekühltes Einzugs-Umlenktrommelpaar und nach der Kühlzone ein Auszugs-Umlenktrommelpaar angeordnet ist.

16. Vorrichtung zur Durchführung des Verfahrens nach einem oder mehreren der vorangehenden Patentansprüche 1 bis 14, **gekennzeichnet** durch eine Doppelbandprsse mit taktweisem Vorschub, die Presse eine erste Zone aufweist, in welcher eine kapazitive Erwärmung durch Hochfrequenz und anschließend eine Abkühlung erfolgt, und vor der Presszone ein gegebenenfalls gekühltes Einzugs-Umlenktrommelpaar, und danach ein Auszugs-Umlenktrommelpaar angeordnet ist.

17. Vorrichtung nach einem der Patentansprüche 15 oder 16, **dadurch gekennzeichnet,** daß vor der Doppelbandpresse in Einzugsrichtung Einrichtungen zum Lagern, Abrollen und Führen der Materialbahnen und der Metallfolien-Bahnen vorgesehen sind.

18. Vorrichtung nach einem der Patentansprüche 15 oder 16, **dadurch gekennzeichnet,** daß vor und nach der Heizzone Isolierungen zur Vermeidung bzw. Beschränkung der Wärmeabstrahlung vorgesehen sind.

19. Vorrichtung nach einem der Patentansprüche 15 oder 16, **dadurch gekennzeichnet,** daß beheizbare Einzugs-Umlenktrommeln für die Metallfolien-Bahnen und Hitzeschilder zum Schutz der Materialbahnen vor Strahlungswärme vorgesehen sind.

20. Vorrichtung nach einem der Patentansprüche 15 oder 16, **dadurch gekennzeichnet,** daß hinter dem Auszugs-Umlenktrommelpaar Randbeschnittvorrichtungen und gegebenenfalls eine Ablängevorrichtung vorgesehen sind.

21. Leiterplatten-Basismaterial, erhalten nach einem der vorhergehenden Patentansprüche 1 bis 20.

FIG.1

1

3

2

FIG.2

0 225 451